# EUROPÄISCHE PATENTSCHRIFT

(11) **EP 2 136 465 B1**
(45) Veröffentlichungstag und Bekanntmachung des Hinweises auf die Patenterteilung: **09.08.2017**
(21) Anmeldenummer: 08011019.0
(22) Anmeldetag: 18.06.2008
(51) Int. Cl.: H02M 7/539, H02M 1/44, H02J 3/38

(54) **Wechselrichter in Brückenschaltung mit langsam und schnell getakteten Schaltern**
Inverter realized by a bridge circuit comprising slow and fast clocked switches
Onduleur realisé par un pont comportant des commutateurs synchronisant lentement et rapidement

(43) Veröffentlichungstag der Anmeldung: 23.12.2009
(73) Patentinhaber: SMA Solar Technology AG, 34266 Niestetal (DE)
(72) Erfinder: Friebe, Jens, 37116 Nörten-Hardenberg (DE); Mallwitz, Regine Dr.-Ing., 34131 Kassel (DE); Zacharias, Peter Prof. Dr.-Ing., 34131 Kassel (DE)
(74) Vertreter: Lahnor, Peter

(56) Entgegenhaltungen:
- EP-A- 1 369 985
- DE-A1- 10 020 537
- DE-A1-102004 063 277
- DE-B3-102004 030 912
- JP-A- 2005 051 926
- ROUND S ET AL: "A SiC JFET driver for a 5 kW, 150 kHz three-phase PWM converter" INDUSTRY APPLICATIONS CONFERENCE, 2005. FOURTIETH IAS ANNUAL MEETING. CONFERENCE RECORD OF THE 2005 HONG KONG, CHINA 2-6 OCT. 2005, PISCATAWAY, NJ, USA,IEEE, Bd. 1, 2. Oktober 2005 (2005-10-02), Seiten 410-416, XP010842402 ISBN: 978-0-7803-9208-3
- CALAIS M ET AL: "Multilevel converters for single-phase grid connected photovoltaic systems: an overview" SOLAR ENERGY, PERGAMON PRESS. OXFORD, GB, Bd. 66, Nr. 5, 1. August 1999 (1999-08-01), Seiten 325-335, XP004362671 ISSN: 0038-092X

## Beschreibung

Die Erfindung betrifft einen Wechselrichter zur Einspeisung einer Leistung einer Gleichspannungsquelle, insbesondere eines Photovoltaikgenerators in ein Wechselspannungsnetz, mit einer asymmetrisch getakteten Brückenschaltung mit mindestens zwei mit Netzfrequenz getakteten ersten Schaltern und mit mindestens zwei mit einer höheren Taktfrequenz getakteten zweiten Schaltern.

Bekannt sind Wechselrichter in Vollbrückenschaltung. Diese können als ein- oder dreiphasige Vollbrücken zur Einspeisung in ein Energienetz ausgeführt sein. Jeder Brückenzweig besteht bei einphasiger Einspeisung aus zwei Schaltern. In den Wechselstromleitungen befindet sich je eine Netzdrossel. Die Schalter der Brückenschaltung können prinzipiell symmetrisch oder asymmetrisch geschaltet werden.

Um die Anordnung von der DC-Seite zu entkoppeln, wird in der DE 10 2004 030 912 B3 vorgeschlagen, einen fünfter Schalter zwischen den Plus-Pol der DC-Quelle und die beiden Brückenzweige anzuschließen. Dieser zusätzliche, fünfte Schalter wird hochfrequent und gleichzeitig mit je einem der beiden unteren Schalter der Brückenzweige geschaltet, während je einer der oberen Schalter der Brückenzweige pro Halbwelle der Netzspannung geschlossen ist. Die Taktung der Schalter erfolgt hier asymmetrisch.

Eine weitere Anordnung ist aus der WO 2008 015 298 A1 bekannt. Die Schrift beschreibt eine Vollbrücken-Anordnung mit einem geteilten Zwischenkreis am Eingang. In jeder DC-Leitung zwischen einem Zwischenkreis und einer Brücke befindet sich je ein Schalter in Reihe. Diese takten abwechselnd hochfrequent aber gleichzeitig mit je einem der beiden unteren Schalter der Brückenzweige, während je einer der oberen Schalter der Brückenzweige pro Halbwelle der Netzspannung geschlossen ist. Die Taktung erfolgt hierbei ebenfalls asymmetrisch. Ein zusätzlicher Freilaufpfad wird durch zwei in Reihe geschaltete Dioden gebildet, die der Brücke vorgeschaltet sind und deren Mittelabgriff mit dem Mittelabgriff des Zwischenkreises verbunden ist.

Bekannt sind außerdem Drei-Level-Anordnungen. Bei dieser Schaltungstopologie besteht ein Brückenzweig aus vier Schaltern. Die beiden mittleren Schaltern werden im Freilauf von zwei in Reihe geschalteten Dioden überbrückt. Diese Schaltung hat den Vorteil, dass die Spannungsbelastung der aktiven Schalter reduziert wird.

Eingesetzt werden bei Wechselrichter dieser Art üblicherweise Schalter wie beispielsweise IGBTs oder MOSFETs.

Bei einer Schaltung gemäß der DE 100 20 537 A1 werden langsam und schnell schaltende Schalter eingesetzt. Hierbei sollen alle Schalter entweder IGBTs oder MOSFETs sein. In gleicher Weise wird in der EP 1 369 985 A2 gelehrt, dass für eine Brückenschaltung mit vier Schaltern ein einziger Schalttyp zweckmäßig ist, und zwar Hochfrequenzschalter, wie MOS-Feldeffekt-Transistoren oder IGBTs.

Aus dem Dokument ROUND S ET AL: "A SiC JFET driver for a 5 kW, 150kHz three-phase PWM converter"; INDUSTRY APPLICATIONS CONFERENCE, 2005. FOURTIETH IAS ANNUAL MEETING; CONFERENCE RECORD OF THE 2005 HONG KONG; CHINA 2-6 OCT. 2005; PISCATAWAY, NJ, USA, IEEE, Bd. 1,2. Oktober 2005 (2005-10-02), Seiten 410 - 416, XP 010842402, ISBN: 978-07803-9208-3 ist bekannt, dass MOSFETs bei Frequenzen über 100kHz einen begrenzte Spannung und einen eingeschränkten Temperaturbereich aufweisen. Für höhere Spannungen und Temperaturen werden SiC Schalter als geeignet dargestellt. Es wird eine Schalterkombination bestehend aus einem SiC JFET und einem Si low voltage MOSFET gezeigt. Diese Schalterkombination ist als ein Bauteil mit vier Anschlüssen ausgeführt, und zwar zwei drain-, ein gate- und ein source-Anschluss. Eine Verwendung beider Schaltertypen (JFET und MOSFET) in einer asymmetrisch getakteten Vollbrücke würde jedoch daran scheitern, dass für beide Schalter (JFET und MOSFET) ein einziger Gate-Anschluss vorhanden ist und somit auch keine unterschiedliche Taktung möglich ist. Es ist praktisch die gate des JFETs intern mit der MOSFET-source verbunden. Dadurch kann dieses Bauteil keine Vollbrücke bilden.

Die JP 2005 05 1926 A beschreibt unterschiedliche Schaltertypen und zwar n-channel-type MOSFET 7U und p-channel-type MOSFET 8U. Diese Schalter sind jedoch MOSFETs und haben die gleiche Temperaturbeständigkeit. Sie unterscheiden sich nur in der Dotierung (p-Typ, n-Typ).

Die DE 10 2004 063 277 A1 erläutert ein Problem bezüglich parasitärer Induktivitäten. Es soll nämlich ein Halbleiterbauelement mit integrierter Stützkapazität geschaffen werden bzw. es sollen Schwankungen in einer Versorgungsspannung vermieden werden bzw. der Fall eines Durchbruchs dieser Kapazitäten behandelt werden.

Der Erfindung liegt die Aufgabe zugrunde, den Wirkungsgrad eines Wechselrichters der genannten Art mit geringen Kosten zu verbessern.

Diese Aufgabe wird dadurch gelöst, dass für die Netzfrequenz langsam schaltende Schalter gleicher Temperatur-beständigkeit eingesetzt werden, dass für die höhere Taktfrequenz schnell schaltende Schalter mit steileren Schaltflanken und höherer Temperaturbeständigkeit eingesetzt werden, wobei die schnell schaltenden Schalter von den langsam schaltenden Schalter räumlich getrennt angeordnet sind, dass mindestens ein zusätzlicher Stützkondensator nah an den schnell schaltenden Schaltern angeschlossen ist, dass die langsam schaltenden Schalter in einer ersten Bauteilgruppe angeordnet sind, während die schnell schaltenden Schalter in einer zweiten Bauteilgruppe räumlich getrennt angeordnet sind, wobei die erste Bauteilgruppe auf einem ersten Substrat und die zweite Bauteilgruppe auf einem zweiten Substrat angeordnet ist.

Durch den teilweisen Einsatz von extrem schnell schaltenden Schaltern mit extrem hoher Temperaturbeständigkeit in Kombination mit langsamer schaltenden und weniger temperaturbeständigen Schaltern kann der Wirkungsgrad des Wechselrichters mit relativ niedrigen Kosten weiter verbessert werden.

Der erfindungsgemäße Wechselrichter ist zur Einspeisung von Wirkleistung in ein elektrisches Energieversorgungsnetz aus einer DC-Quelle, z. B. aus Photovoltaikmodulen oder Brennstoffzellen, unter Verwendung von unterschiedlich schnell schaltenden Bauteilen sehr geeignet.

Die Erfindung beruht auf der Erkenntnis, dass im Verlauf der Bauelementeentwicklung mit deutlich schneller schaltenden Schaltern aber auch höheren zulässigen Betriebstemperaturen für diese Schalter zu rechnen ist. Dadurch sind deutliche Wirkungsgradsteigerungen zu erwarten. Von dieser Entwicklung betroffen sind insbesondere Bauteile aus Silizium (Si), wie beispielsweise Si-IGBTs oder Si-MOSFETs, und in besonderem Maße Bauteile aus Siliziumkarbid (SiC).

Extrem niedrige Schaltverluste sind nämlich mit extrem steilen Schaltflanken verbunden. Die extremen Schaltflanken erfordern jedoch besondere Sorgfalt bei der Gestaltung der Kommutierungskreise. Die parasitäre Induktivität der Kommutierungskreise muss minimale Werte annehmen bzw. in ihrer Wirkung beschränkt werden. Durch die räumliche Trennung von langsam und schnell schaltenden Schaltern, verbunden mit Stützkondensatoren für die Kommutierungsspannung ist eine Schaltung mit niedriger parasitärer Induktivität in einfacher Weise möglich.

Werden in einer Schaltung Schalter verschiedener Entwicklungsgenerationen eingesetzt, die sich durch unterschiedlich hohe Temperaturbeständigkeit auszeichnen, wird dies in der räumlichen Anordnung berücksichtigt. Nur durch eine räumliche Trennung lassen sich die Vorteile einer höheren zulässigen Betriebstemperatur überhaupt ausnutzen. Gleichzeitig wird der Forderung nach einer geringen parasitären Induktivität Rechnung getragen. Die parasitäre Induktivität ist um so kleiner, je kürzer die Zuleitungen zwischen den schaltenden Bauteilen sind. Die räumliche Trennung der unterschiedlichen Schalter erlaubt bei der asymmetrischen Taktung kurze Zuleitungen für die Kommutierungsspannung.

Erfindungsgemäß wird die Aufgabe also praktisch dadurch gelöst, dass die Kommutierungskreise mit gleich schnell schaltenden Schaltern gleicher Temperaturbeständigkeit aufgebaut werden. Dies ist besonders gut möglich, wenn die Schaltung asymmetrisch getaktet wird.

Die schnell schaltenden Schaltern gleicher und hoher Temperaturbeständigkeit werden von den langsam schaltenden Schaltern geringerer Temperatur-beständigkeit räumlich getrennt angeordnet. Dadurch kann tatsächlich eine höhere Betriebstemperatur für die schnellen Schalter gewährleistet werden. Der Vorteil der höheren Betriebstemperatur kann somit ausgenutzt werden. Es ist weniger Aufwand notwendig, die entstehende Wärme abzuführen.

Die an den Kommutierungsvorgängen beteiligten Schalter können wiederum räumlich nah beieinander angeordnet werden, wodurch die parasitäre Induktivität im Kommutierungskreis auf minimale Werte beschränkt wird.

Durch die Erfindung können außerdem EMV-Probleme minimiert werden, und zwar durch die Nutzung der Schaltereigenschaften und die erfindungsgemäße elektrische Anbindung der Bauteile.

Erfindungsgemäß sind die langsam schaltenden Schalter in einer ersten Bauteilgruppe angeordnet, während die schnell schaltenden Schalter in einer zweiten Bauteilgruppe räumlich getrennt angeordnet sind. Die schneller schaltenden und temperaturbeständigeren Schalter bilden also eine erste Bauteilgruppe. Die langsamer schaltenden und weniger temperaturbeständigeren Schalter bilden eine zweite Bauteilgruppe. Beide Baugruppen werden voneinander getrennt aufgebaut. Diese Zuordnung erlaubt sowohl eine gute thermische Trennung als auch eine geringe parasitäre Induktivität im Kommutierungskreis.

Die Erfindung zeichnet sich auch dadurch aus, dass mindestens ein zusätzlicher Stützkondensator nah an den schnell schaltenden Schaltern angeschlossen ist. Vorzugsweise ist der Stützkondensator in der ersten Bauteilgruppe der schnellen Schalter vorhanden. Dieser begrenzt zusätzlich die Spannung über den schnell schaltenden Schaltern. Durch das Einbringen eines zusätzlichen Stützkondensators möglichst nah an den schnell schaltenden Bauelementen, können auftretende Überspannungsspitzen während eines Schaltvorgangs reduziert werden.

Ein verbesserter Wirkungsgrad ergibt sich dann, wenn die Schalter in Montage- Module integriert sind, wobei vorzugsweise die Schalter als Chips innerhalb eines Moduls ausgeführt sind. Der Aufbau in einem Montage-Modul mit mindestens zwei Substraten minimiert parasitäre Induktivitäten, wobei die erste Bauteilgruppe auf dem ersten Substrat und die zweite Bauteilgruppe auf dem zweiten Substrat angeordnet sind. Eine besonders niedrige parasitäre Induktivität wird erreicht, weil die Schaltungsanordnung in einem Montage-Modul integriert wird, da die Schalter als Chips innerhalb eines solchen Moduls besonders nah beieinander angeordnet werden und dadurch Leiterbahnen und Bonddrähte sehr kurz gehalten werden können. Bei Verwendung diskreter Bauelemente ist jeder Schalter, d. h. Chip, separat verpackt. Das heißt innerhalb des Gehäuses befinden sich Leiterbahnen und Bonddrähte, und außerhalb des bzw. der Gehäuse befinden sich weitere Leiterbahnen auf einer zum Beispiel externen Leiterkarte.

Weitere vorteilhafte Ausgestaltungen der Erfindung sind in den Unteransprüchen gekennzeichnet.

In einer vorteilhaften Weiterbildung des erfindungsgemäßen Wechselrichters ist vorgesehen, dass für die schnell schaltenden Schaltern und die langsam schaltenden Schalter jeweils verschiedene Kühlkörper oder thermisch voneinander separierte Montageflächen vorhanden sind, auf denen die Schalter montiert sind. Der Aufbau mit diskreten Bauteilen erfolgt insbesondere auf zwei Kühlkörpern, wobei die erste Baugruppe auf dem ersten Kühlkörper und die zweite Baugruppe auf dem zweiten Kühlkörper angeordnet sind. Dadurch ist einerseits eine getrennte Montage möglich und andererseits eine thermische Entkopplung der unterschiedlichen Schalter gegeben. Dies bedeutet, dass Schalter mit niedriger Temperaturbeständigkeit bzw. niedrigen Temperaturgrenzwerten einsetzbar sind, und zwar ohne dass überdimensionierte Kühlkörper notwendig sind. Die Kühlkörper lassen sich optimal an die Schalter anpassen. Durch diese Schalter und die getrennten Kühlkörper kann ein hoher Wirkungsgrad trotz geringer Abmessungen und Kosten erreicht werden. Ein solcher Aufbau ist prinzipiell mit diskreten Bauteilen möglich. Vorteilhaft ist hierbei, dass zwei verschiedene Kühlkörper unterschiedlicher Leistungsfähigkeit verwendet werden können. Die Kühlkörper sind praktisch untereinander thermisch isoliert bzw. entkoppelt, durch z. B. einen Luftspalt.

Besonders günstig ist es außerdem, dass die schnell schaltenden Schalter als SiC-Bauelemente ausgeführt sind. Besteht der Kommutierungskreis nur oder teilweise aus den schnell schaltenden SiC-Bauteilen mit einer sehr hohen Temperaturbeständigkeit, bedeutet dies, dass der schnell schaltende Kommmutierungskreis prinzipiell stärker als der langsam schaltende Bereich erwärmt werden darf. Durch kurze Schaltzeiten sind aber auch sehr hohe Taktfrequenzen erreichbar. Dadurch ist eine erhebliche Wirkungsgradverbesserung möglich.

Zweckmäßigerweise sind die langsam schaltenden Schalter als Si-Bauelemente, beispielsweise als MOSFET- oder IGBT-Schalter ausgeführt. Diese Schalter sind ausreichend, da sie mit einer verhältnismäßig geringen Frequenz, und zwar der Netzfrequenz, getaktet werden. Diese haben sich bei Photovoltaikwechselrichtern sehr bewährt.

Eine Schalterkombination von MOSFET- oder IGBT-Schalter mit SiC-JFETs ist bei asymmetrischer Taktung optimal.

Um den Wirkungsgrad weiter zu verbessern, ist außerdem vorgesehen, dass zwischen der Gleichspannungsquelle und der Brückenschaltung ein Entkopplungsschalter angeschlossen ist, der synchron mit den schnell schaltenden Schaltern getaktet ist. Durch diese Entkopplung werden hochfrequente Ströme reduziert, die bei Photovoltaikmodulen aufgrund ihrer Kapazität zur Erde nachteilig sind.

Alternativ können aber auch mehrere Entkopplungsschalter, insbesondere zwei Entkopplungsschalter, innerhalb der Brücke vorhanden sein.

Die Entkopplungsschalter sind mit Vorteil SiC-Bauelemente, insbesondere SiC-FETs, weil sie mit gleicher Taktfrequenz, wie die schnell schaltenden Schalter der Brücke, angesteuert werden.

Vorteilhaft ist auch das Zuschalten schneller Freilaufdioden an den langsamen Schaltern bzw. den MOSFETs oder IGBTs, die jedoch räumlich den schnell schaltenden Schaltern bzw. den SiC-Schaltern zugeordnet sind. Insbesondere sind daher parallel an den langsamen Schaltern als Schottky-Dioden ausgeführte Freilaufdioden angeschlossen. Während der Freilaufphasen, die hochfrequent aufeinanderfolgen, wirkt sich ein schnelles Schalten der Dioden günstig auf den Wirkungsgrad aus.

Damit der Wirkungsgrad weiter verbessert wird, ist der Wechselrichter mit Vorteil als Multi-Level-Wechselrichter, insbesondere als Drei-Level-Wechselrichter ausgeführt.

Besonders relevant ist eine Ausführung als Photovoltaikwechselrichter. Hier ist der Wirkungsgrad einer Stromerzeugungsanlage sehr wichtig. Aber auch eine gute EMV (Elektromagnetische Verträglichkeit), kapazitive Ableitströme der Photovoltaikmodule und eine kompakte Bauform spielen eine erhebliche Rolle für die Marktfähigkeit der Produkte.

Durch die Erfindung wird ein Photovoltaikwechselrichter entscheidend verbessert. Bei der weiteren Optimierung derartiger Wechselrichter stehen eine Steigerung des Wirkungsgrades sowie eine Verminderung der Kosten bei der Fertigung im Vordergrund.

Ein Ausführungsbeispiel wird anhand der Zeichnungen näher erläutert, wobei weitere vorteilhafte Weiterbildungen der Erfindung und Vorteile derselben beschrieben sind.

Es zeigen:
- Fig. 1: eine Vollbrücke zur Einspeisung in ein Wechselspannungsnetz aus einer DC-Quelle,
- Fig.2: die Vollbrücke nach Fig. 1 mit räumlich getrennten Bereichen für schnelle und langsam schaltende Schalter,
- Fig. 3a: einen Aufbau der Schaltungsanordnung nach Fig. 1 bzw. Fig. 2 mit diskreten Bauelementen,
- Fig. 3b: den Aufbau von der Seite,
- Fig. 3c: eine Darstellung eines Halbleitermoduls nach Fig. 3e von der Seite gesehen,
- Fig. 3d: eine Darstellung des Halbleitermoduls von unten gesehen,
- Fig. 3e: eine Ausführung der Anordnung nach Fig.1 bzw. Fig. 2 in einem Halbleitermodul mit zwei Substraten,
- Fig. 4: eine H5-Schaltung zur Einspeisung in ein Energieversorgungsnetz aus einer DC-Quelle mit einem zusätzlichen Entkopplungsschalter,
- Fig. 5a: zeigt eine Ausführung der Anordnung der in Fig. 4 gezeigten Schaltungstopologie mit auf zwei Kühlkörpern verteilten diskreten Schaltern,
- Fig. 5b: die Anordnung nach Fig. 5a von der Seite gesehen,
- Fig. 5c: eine Darstellung des Halbleitermoduls nach Fig. 5e von der Seite gesehen,
- Fig. 5d: eine Darstellung des Halbleitermoduls nach Fig. 5e von unten gesehen,
- Fig. 5e: eine Ausführung der in Fig. 4 gezeigten Topologie in einem Halbleitermodul mit zwei Substraten,
- Fig. 6: eine einphasige Drei-Level-Anordnung zur Einspeisung in ein Energieversorgungsnetz aus einer DC-Quelle,
- Fig. 7a: eine Ausführung der in Fig. 6 gezeigten Schaltungstopologie mit auf zwei Kühlkörpern verteilten diskreten Schaltern,
- Fig. 7b: die Anordnung nach Fig. 7a von der Seite gesehen,
- Fig. 7c: eine Darstellung des Halbleitermoduls nach Fig. 7e von der Seite gesehen,
- Fig. 7d: eine Darstellung des Halbleitermoduls nach Fig. 7e von unten gesehen, und
- Fig. 7e: eine Ausführung der in Fig. 6 gezeigten Schaltungstopologie in einem Halbleitermodul mit zwei Substraten.

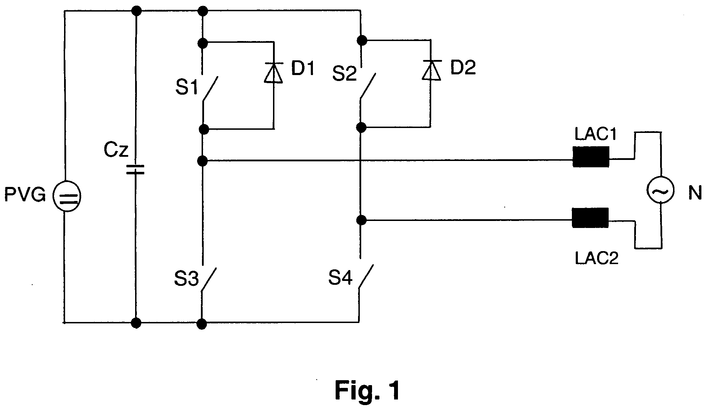

Fig. 1 zeigt eine Vollbrücke zur Einspeisung in ein Wechselspannungsnetz N, vorzugsweise dem Energieversorgungsnetz aus einer DC-Quelle bzw. einer Gleichspannungsquelle, insbesondere aus einem Photovoltaikgenerator PVG.

Der Generator PVG speist die Vollbrücke bestehend aus vier Schaltern S1, S2, S3 und S4. Diese Schalter sind Halbleiterschalter, wobei zwei erste, obere Schalter S1, S2 und zwei zweite, untere Schalter vorhanden sind. Die Bezeichnung "obere und untere Schalter" dient nur der leichteren Erklärung. Grundsätzlich können die Schalter S3, S4 auch oben, also am Pluspol geschaltet sein. Die Schaltung ist zwar einphasig gezeigt, sie kann aber auch dreiphasig mit sechs Schaltern, also drei obere und drei untere Schalter ausgeführt sein.

Parallel zum Generator PVG ist ein Kondensator Cz als Puffer geschaltet. Weiterhin umfasst die Schaltung zwei Netzdrosseln LAC1 und LAC2. Die Schaltung ist einphasig ausgeführt. Die Brücke wird asymmetrisch getaktet. Die ersten bzw. oberen Schalter S1, S2 werden mit Netzfrequenz, also mit unterschiedlicher Frequenz getaktet als die zweiten bzw. unteren Schaltern S3, S4, die mit einer hohen Frequenz von insbesondere mindestens oder mehr als 1 kHz, vorzugsweise mehr als 5 kHz getaktet werden.

Weil die Anordnung asymmetrisch getaktet wird, ist dem oberen Schalter S1 eine Diode D1 und dem oberen Schalter S2 eine Diode D2 antiparallel zugeschaltet. Während der positiven Halbwelle der Netzspannung ist dann der Schalter S1 geschlossen und der Schalter S4 wird hochfrequent getaktet. Ist der untere Schalter S4 geschlossen, fließt ein Strom über einen oberen Schalter S1 und den unteren Schalter S4 sowie über den Netzdrosseln LAC1 und LAC2 in das Wechselstromnetz N, insbesondere in ein Energienetz. Dieses kann auch ein Inselnetz sein. Ist der Schalter S4 offen, bildet sich ein Freilaufkreis. Der Strom fließt über den oberen Schalter S1, die Diode D2 und die beiden Netzdrosseln LAC1 und LAC2 ins Energienetz.

Während der negativen Halbwelle der Netzspannung ist der andere obere Schalter S2 geschlossen, wobei der untere Schalter S3 hochfrequent getaktet wird. Ist der untere Schalter S3 geschlossen, fließt ein Strom über den oberen Schalter S2 und diesen Schalter S3 sowie die beiden Netzdrosseln LAC1 und LAC2 ins Energienetz. Es entsteht ein Freilaufkreis, wenn der untere Schalter S3 offen ist. Dieser wird aus dem oberen Schalter S2, der Diode D1 und den Drosseln LAC1, LAC2 und dem Netz N gebildet. Ein analoger Freilaufkreis entsteht also, wenn der andere untere Schalter S4 offen ist.

Die Anordnung nach Fig. 1 umfasst zumindest teilweise schnell schaltende Bauelemente, wie Halbleiterschalter und Dioden, insbesondere SiC-JFET. Die zweiten bzw. unteren Schalter S3 und S4 werden als schnell schaltende Schalter, beispielsweise selbstleitende SiC-JFET, ausgeführt. Für die ersten, oberen Schalter S1 und S2 werden herkömmliche Schalter, beispielsweise MOSFETs oder IGBTs aus Silizium, eingesetzt. Besonders vorteilhaft ist es jedoch, wenn die oberen Schalter S1 und S2 IGBTs sind. Dann können nämlich für die Freilaufdioden D1 und D2 ebenfalls besonders schnell schaltende Dioden, beispielsweise SiC Schottky Dioden verwendet werden. Damit ist ein besonders hoher Wirkungsgrad erreichbar.

Mit der Schaltung nach Fig. 1 und der beschriebenen Schalterwahl wird auch ein Kurzschluss der DC-Seite vermieden. Die AC- also Netzseite wird aus Schutzgründen bei ausgeschaltetem Gerät mit einem Netzrelais getrennt und es wird somit kein Kurzschluss erzeugt. Das Zu- und Abschalten des Netzes erfolgt durch eine Betriebsführung.

Erfindungsgemäß werden die schnell schaltenden Schalter S3, S4 also die SiC- Bauteile räumlich von den Si- Bauteilen bzw. den langsamen Schaltern S1, S2 getrennt. Dies hat den Vorteil, dass die Si-Schalter S1, S2 räumlich nah beieinander angeordnet werden können. Durch diese Maßnahme können parasitäre Induktivitäten auf ein Minimum reduziert werden. Ein weiterer Vorteil besteht darin, dass jeder Si- bzw. SiC-Bauteil-Bereich anderen Bedingungen, z.B. anderen Temperaturen, ausgesetzt werden kann. Die SiC- Schalter S3, S4 können beispielsweise bei wesentlich höheren Temperaturen betrieben werden. Die unteren Schalter S3, S4 sowie die Dioden D1 und D2 sind schnell schaltend und hoch temperaturbeständig ausgeführt.

Es werden also für die mit Netzfrequenz langsam schaltenden Schalter S1, S2 gleicher Temperaturbeständigkeit eingesetzt und für die höhere Taktfrequenz schnell schaltende Schalter S3, S4 mit steileren Schaltflanken und hoher Temperaturbeständigkeit eingesetzt, wobei die schnell schaltenden Schalter S3, S4 von den langsam schaltenden Schalter S1, S2 räumlich getrennt angeordnet sind.

Die langsam schaltenden Schalter S1, S2 sind insbesondere in einer ersten Bauteilgruppe angeordnet, während die schnell schaltenden Schalter S3, S4 in einer zweiten Bauteilgruppe räumlich angeordnet sind.

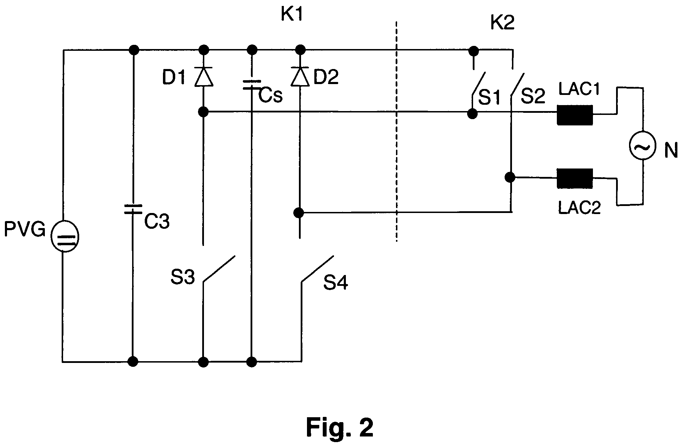

Fig. 2 zeigt, wie die Bauteile räumlich anzuordnen sind. Die Anordnung entspricht weitgehend der Schaltung nach Fig. 1. Die hochfrequent getakteten Kommutierungskreise, bestehend aus einerseits der Diode D1 und dem unteren Schalter S3 und andererseits der Diode D2 und dem anderen unteren Schalter S4, bilden eine Bauteilgruppe. Die netzfrequent getakteten Schalter S1 bzw. S2 bilden eine zweite Bauteilgruppe (vgl. gestrichelte Linie).

Parallel zu den beiden Zweigen, bestehend aus einerseits der Diode D1 und dem unteren Schalter S3 und andererseits der Diode D2 und dem anderen unteren Schalter S4, ist zusätzlich ein Stützkondensator Cs geschaltet, und zwar nahe der schnellen Schalter S3, S4.

Durch den Stützkondensator Cs wird verhindert, dass sich die Spannungen an den Halbleiterschaltern durch die parasitären Induktivitäten auf große Werte aufbauen können. Jeder Verbindung in der dargestellten Topologie kann eine parasitäre Induktivität Ls zugeordnet werden. Je kürzer diese Verbindungen sind, um so kleiner ist die parasitäre Induktivität Ls.

Die parasitäre Induktivität verursacht beim Schalten eine zusätzliche Spannung Us = Ls x di/dt. Dadurch werden die Bauteile zusätzlich beansprucht. Es entstehen höhere Schaltverluste und die Schalter müssen für die resultierende Spannung ausgelegt sein. Die zusätzliche induzierte Spannung Us ist umso höher, je schneller die Schalter schalten, das heißt, je höher der Stromanstieg di/dt ist. Darum ist es wichtig, für schnell schaltende Schalter die parasitären Induktivitäten so gering wie möglich zu halten.

Die Schalter werden asymmetrisch getaktet, und zwar hochfrequent an einem Pol. Durch das unipolare Takten entsteht ein Kommutierungskreis, der nur über die schnell schaltenden Bauteile, und zwar der Diode D1 und den unteren Schalter S3 bzw. der Diode D2 und den anderen unteren Schalter S4, geschlossen wird und daher räumlich nicht an die langsam schaltenden Schalter S1 bzw. S2 gekoppelt werden muss.

Eine räumliche Trennung von schnell und langsam schaltenden Bauelementen kann auf unterschiedliche Weise erreicht werden, beispielsweise durch diskrete Bauelemente auf verschiedenen Kühlkörpern und/oder innerhalb eines Halbleitermoduls. Eine Kombination von diskreten Bauelemente und Halbleitermodulen ist auch möglich. Es können z.B. diskrete Schalter S1, S2 und Halbleitermodulschalter S3, S4 eingesetzt werden.

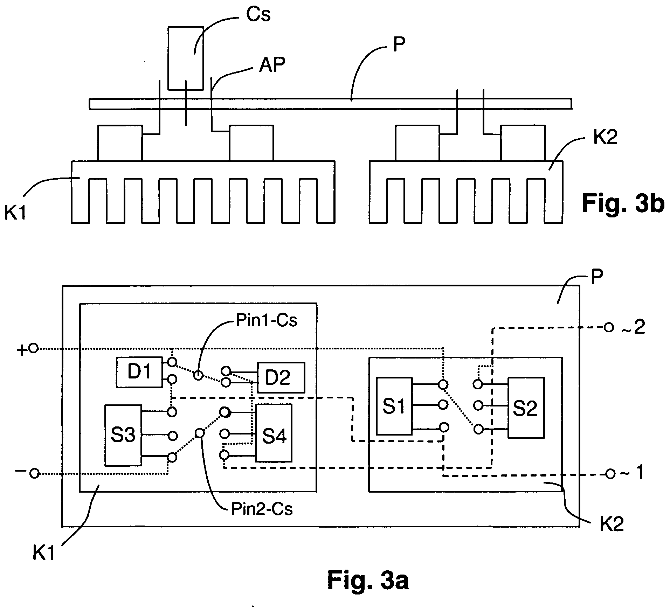

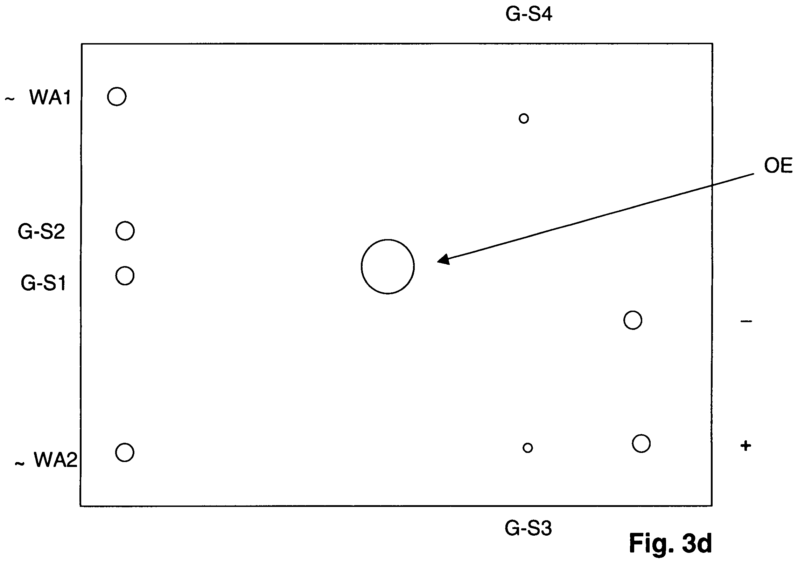

Fig. 3a und Fig. 3b zeigen den Aufbau der Schaltung nach Fig. 1 bzw. Fig. 2 mit diskreten Bauelementen. Die Bauteilgruppen sind vorteilhaft auf verschiedenen Kühlkörpern K1, K2 angeordnet. Die schnell schaltenden Schalter S3, S4 und die Dioden D1, D2 werden thermisch mit dem Kühlkörper K1 verbunden. Die langsam schaltenden Schalter S1, S2 werden mit dem Kühlkörper K2 verbunden. Der Kühlkörper K1 der schnell schaltenden Schalter S3, S4 ist z.B. größer als der Kühlkörper K2 der langsam schaltenden Schalter S1, S2. Die Kühlkörper K1, K2 sind nebeneinander angeordnet. Über den auf den Kühlkörpern K1, K2 montierten Schaltern und Dioden befindet sich eine Platine P mit einem Layout. Die Anschluss-Pins AP der Schalter und Dioden sind mit den Leiterbahnen der Platine P elektrisch verbunden, beispielsweise verlötet.

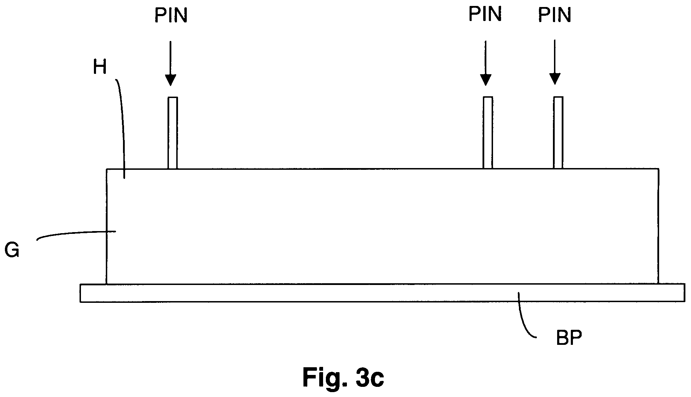

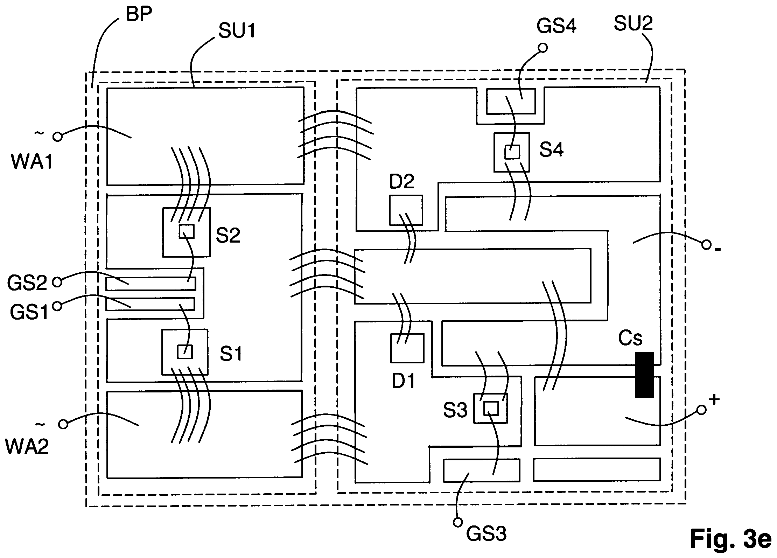

Die Figuren 3c bis 3e zeigen ein Gehäuse G und das Layout für zwei Substrate SU1, SU2 eines Montage-Moduls, insbesondere eines Halbleitermoduls H. Selbstverständlich sind auch handelsübliche Gehäuse verwendbar. Die langsam schaltenden Schalter S1 und S2 sind auf das Substrat SU1 gelötet. Von diesem Substrat führen die Wechselstromanschlüsse WA1 und WA2 sowie die Steueranschlüsse GS1 für den oberen Schalter S1 und GS2 für den anderen oberen Schalter S2 ab. Die schnell schaltenden Schalter S3 und S4 sind auf das Substrat SU2 gelötet. Von diesem Substrat führen die Gleichstromanschlüsse + und - sowie die Steueranschlüsse GS3 für den unteren Schalter S3 und GS4 für den anderen unteren Schalter S4 ab. Auf das Substrat SU2 ist ebenfalls der Stützkondensator Cs gelötet. Cs ist hier beispielsweise als SMD-Bauteil ausgeführt. Es sind auch andere Ausführungsformen verwendbar. In Fig. 3e sind alle Schalter S1 bis S4 bzw. alle Dioden D1 und D2 als jeweils ein Chip ausgeführt. Jeder Schalter bzw. jede Diode kann auch durch mehrere parallel geschaltete Chips ausgeführt werden.

Für die Anschlüsse werden Pins PIN auf Kupferflächen gelötet. Alternativ können Bonddrähte zu Pin-Anschlüssen führen, die zum Beispiel in einem Kunststoffrahmen stecken.

Die Substrate SU1, SU2 werden auf eine gemeinsame Bodenplatte BP gelötet. Auf die Bodenplatte BP wird das Kunststoffgehäuse G geklebt, das mit Durchführungen für die Pins PIN versehen ist und in das über eine weitere Öffnung OE ein Isolationsmaterial in das Gehäuseinnere geleitet wird. Vorzugsweise ist dies ein Weichverguss.

Alternativ kann auf die Bodenplatte BP ein Kunststoffrahmen gesetzt werden, in den Anschluss-Pins PIN gesteckt werden. Das Modul wird mit Isolationsmaterial gefüllt und einem Deckel z.B. durch Klebung verschlossen.

Das Prinzip der räumlichen Trennung und das Einbringen eines zusätzlichen Stützkondensators Cs ist ebenfalls auf andere Schaltungstopologien anwendbar. Dazu gehören neben der bereits beschriebenen Vollbrücke beispielsweise auch die im Stand der Technik beschriebenen Anordnungen mit mindestens einem Entkopplungselement, zum Beispiel nach der DE 10 2004 030 912 B3, oder nach dem zitiertem Gonzales-Aufsatz oder der genannten Drei-Level-Topologie.

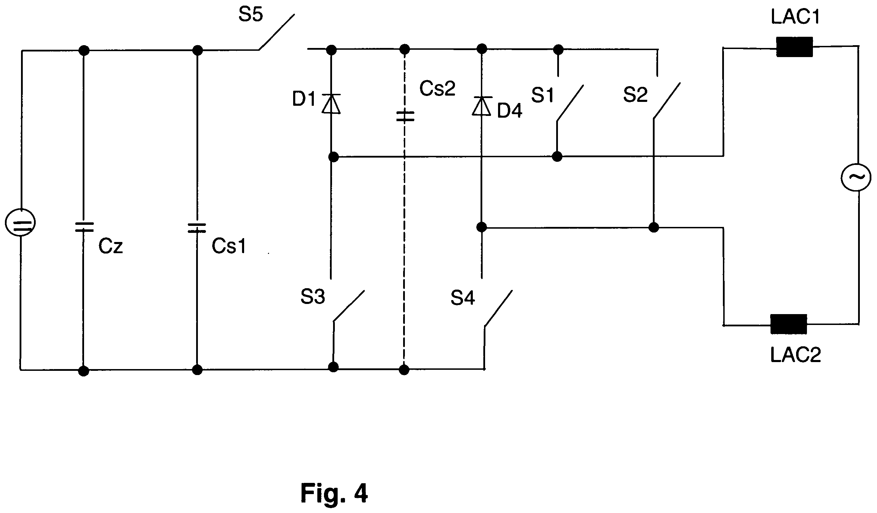

Fig.4 zeigt eine Anordnung zur Einspeisung in ein Energieversorgungsnetz aus einer DC-Quelle, insbesondere einem Photovoltaikgenerator (PVG), mit einem zusätzlichen Entkopplungsschalter S5. Die unteren Schalter S3, S4 und der zusätzliche Schalter S5 sowie die Dioden D1 und D2 sind schnell schaltend und hoch temperaturbeständig ausgeführt. Diese Bauteile bilden die erste Bauteilgruppe. Ein erster Stützkondensator Cs2 ist analog zum vorherigen Beispiel angeschlossen. Ein zweiter Stützkondensator Cs1 wird parallel zum Pufferkondensator Cz angeordnet. Der zweite Stützkondensator Cs1 ist jedoch kleiner, insbesondere wesentlich kleiner als der Pufferkondensator Cz. Der zweite Stützkondensator Cs1 ist in der ersten Bauteilgruppe nahe den Schaltern S3, S4 angeordnet. In einer weiteren Ausgestaltung kann der Stützkondensator Cs2 auch parallel zu den Brückenzweigen, wie in Fig. 2 gezeigt ist, angeordnet werden. Für diese Variante ist in Fig.4 ein Stützkondensator Cs2 gestrichelt dargestellt.

Die oberen Schalter S1 und S2 in Fig. 4 sind die langsam schaltenden und weniger temperaturbeständigen Schalter und bilden die zweite Bauteilgruppe.

Die Ansteuerung erfolgt wie für die in Fig. 1 bzw. Fig. 2 gezeigten Schaltung asymmetrisch. Im Unterschied dazu befindet sich jedoch der fünfte Schalter S5 vor der Brücke. Dieser schaltet gleichzeitig hochfrequent und synchron mit jeweils einem der unteren Schalter S3 bzw. S4.

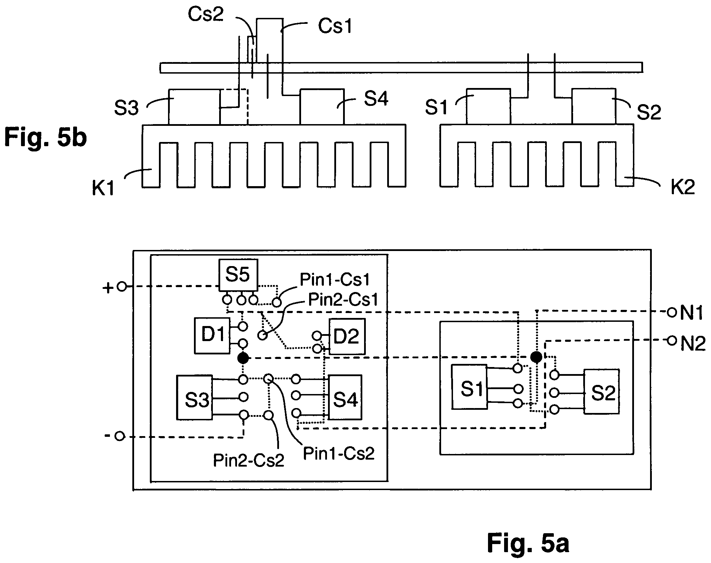

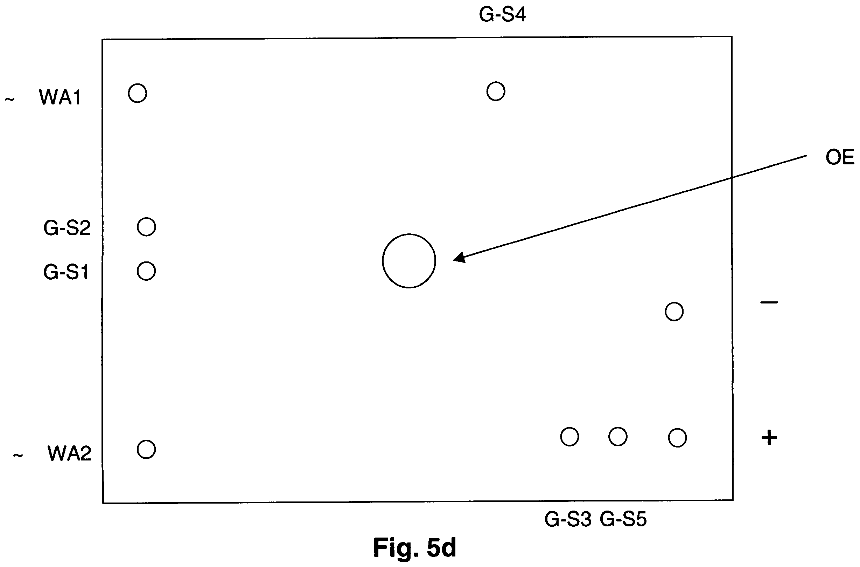

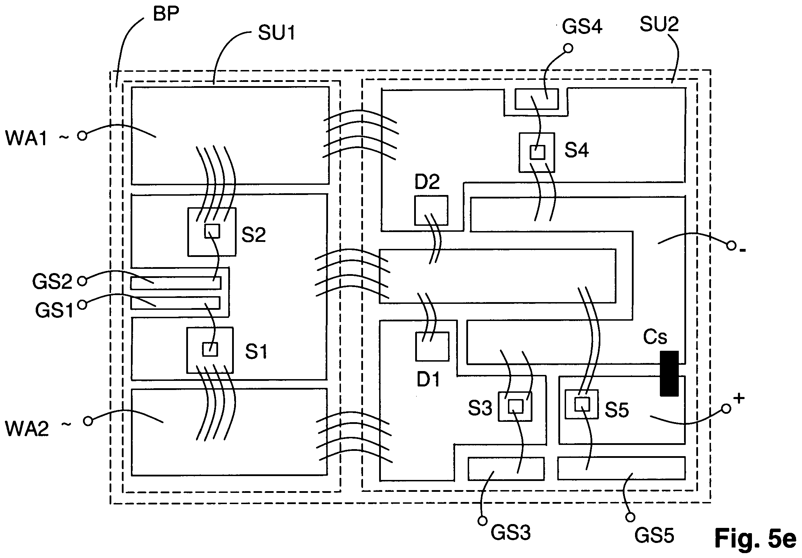

Fig.5a und Fig. 5b zeigen eine Ausführung der in Fig. 4 gezeigten Topologie mit auf zwei Kühlkörpern K1, K2 verteilten diskreten Schaltern. Der Aufbau ist nahezu identisch mit dem in Fig. 3a gezeigten Aufbau. Im Unterschied zur Ausführung in Fig. 3a ist auf dem Kühlkörper K1 zusätzlich der fünfte Schalter S5 angeordnet.

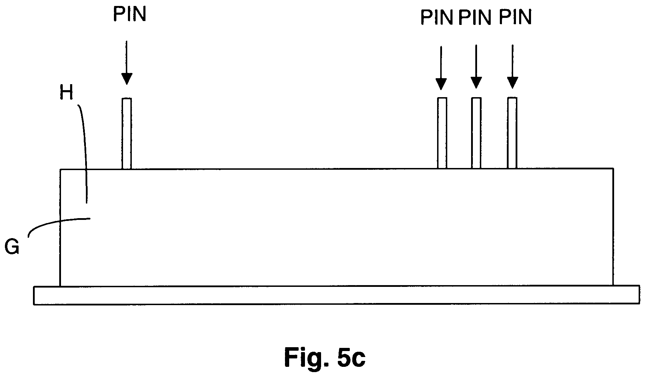

Die Figuren 5c bis 5e zeigen eine Ausführung der in Fig. 4 gezeigten Schaltungstopologie in einem Montage-Modul, insbesondere einem Halbleitermodul H mit zwei Substraten SU1, SU2. Der Aufbau ist nahezu identisch mit dem in den Figuren 3c bis 3e gezeigten Aufbau. Im Unterschied zu diesem Aufbau ist auf dem Substrat SU2 noch der Schalter S5 angeordnet. Damit hat das Modul auch einen weiteren Anschluss, nämlich einen Steueranschluss GS5 für den fünften Schalter S5. Diese Schaltung wird als H5- Brücke bezeichnet. Die Bodenplatte BP ist vorzugsweise aus Metall.

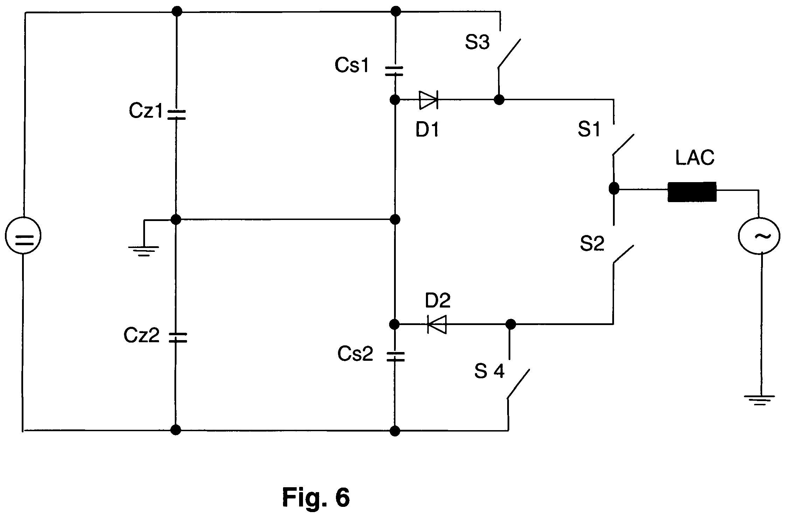

Fig.6 zeigt eine Multi-Level-Schaltung, insbesondere eine Drei-Level-Schaltung zur einphasigen Einspeisung in das Energieversorgungsnetz N mit der DC-Quelle bzw. dem Photovoltaikgenerator PVG. Die Schaltung besteht aus einem geteilten Zwischenkreis, das heißt, es sind zwei Kondensatoren Cz1 und Cz2 in Reihe geschaltet. Der Mittelpunkt ist geerdet.

Parallel zum Zwischenkreis ist ein Brückenzweig angeordnet. Dieser Brückenzweig besteht aus vier in Reihe geschalteten Schalter S1 bis S4. Die Schalter S1, S2 sind innen und die Schalter S3, S4 außen angeordnet.

Parallel zu den beiden mittleren Schaltern S1 und S2 des Brückenzweiges sind zwei in Reihe geschaltete Dioden D1 und D2 angeordnet. Der Verbindungspunkt dieser Dioden ist mit dem geerdeten Mittelpunkt des Zwischenkreises verbunden. Vorzugsweise befinden sich zwei Stützkondensatoren Cs1 und Cs2 in der Anordnung. Und zwar ist der Kondensator Cs1 parallel zur Reihenschaltung bestehend aus dem Schalter S3 und der Diode D1 geschaltet und der Kondensator Cs2 parallel zur Reihenschaltung bestehend aus dem Schalter S4 und der Diode D2 geschaltet.

Die Schalter takten ebenfalls asymmetrisch. Die Schalter S1 und S2 werden mit Netzfrequenz angesteuert. Während der positiven Halbwelle der ausgangsseitigen Wechselspannung ist der Schalter S1 geschlossen, wobei der Schalter S3 hochfrequent taktet. Ist der Schalter S1 geschlossen, fließt ein Strom über die Schalter S3, S1 und die Netzdrossel LAC ins Netz N. Ist der Schalter S3 geöffnet, fließt ein Strom über den Freilaufkreis, mit den Bauelementen S1, D1 und Ground.

Während der negativen Halbwelle der ausgangsseitigen Wechselspannung ist der Schalter S2 geschlossen und der Schalter S4 taktet hochfrequent. Der Freilaufkreis wird dann über die Bauteile S2, D2 und Ground gebildet.

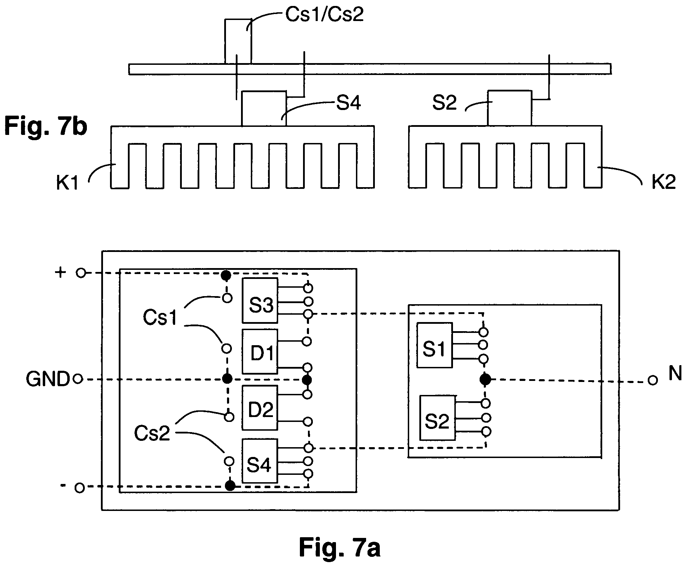

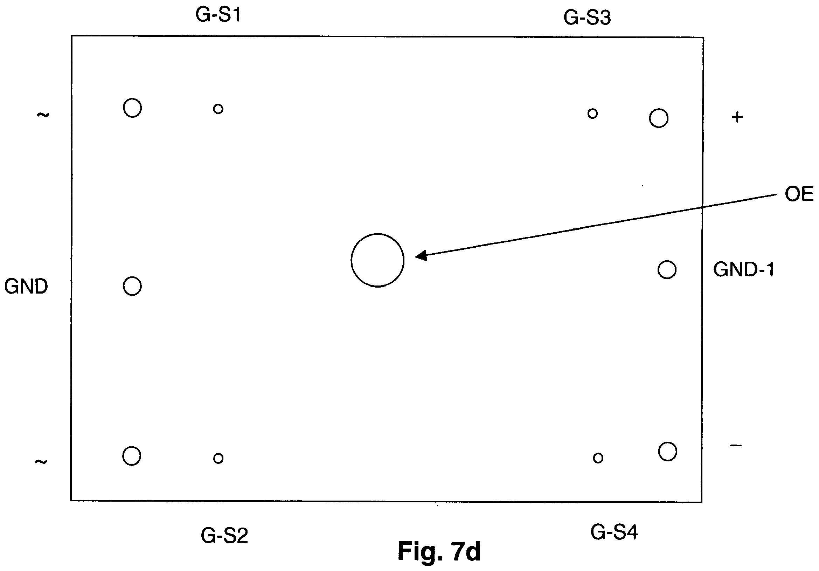

Die Figuren 7a und 7b zeigen eine Ausführung der in Fig. 6 gezeigten Topologie mit auf zwei Kühlkörpern K1 und K2 verteilten diskreten Schaltern.

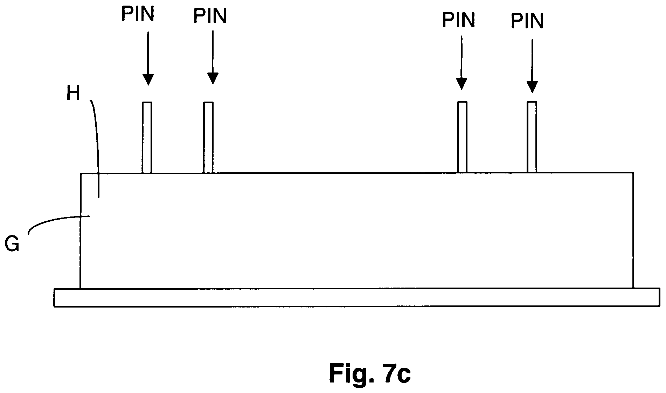

Die Figuren 7c bis 7e zeigen eine Ausführung der in Fig. 6 gezeigten Topologie in einem Montage-Modul, vorzugsweise ine einem Halbleitermodul H. Das Modul ist ähnlich aufgebaut wie das für die Vollbrücke bzw. die H5- Brücke. Ein Unterschied besteht in der Anordnung und der Belegung der Anschluss-Pins PIN, wie die Figuren zeigen.

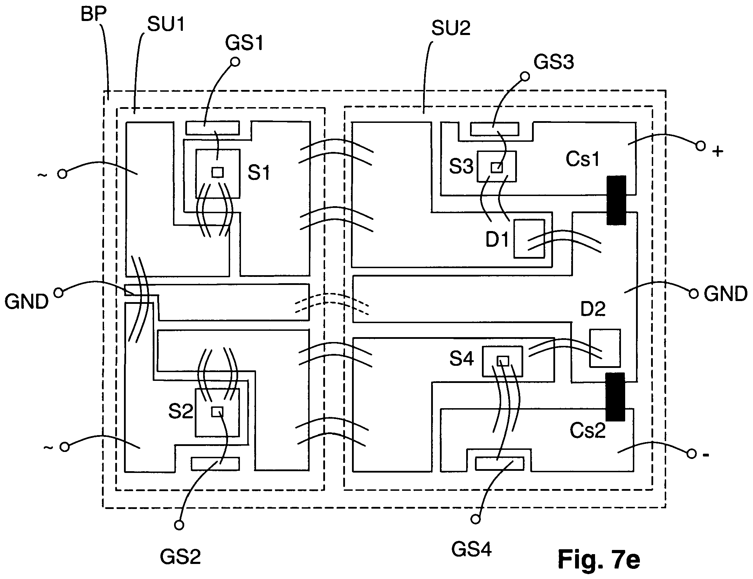

Auch dieses Modul wird mit zwei Substraten SU1 und SU2 aufgebaut. Das Substrat SU1 umfasst die langsam schaltenden Schalter S1, S2 mit geringer Temperaturbeständigkeit. Das Substrat SU2 die schnell schaltenden Schalter S3, S4 mit hoher Temperaturbeständigkeit. Die Erdungspunkte GND der Substrate SU1 und SU2 können intern durch Bonds miteinander verbunden werden. Da dies optional erfolgen kann, ist diese Verbindung gestrichelt eingezeichnet. Werden mehrerer dieser Module parallel geschaltet, kann in mehrere Phasen eingespeist werden. Jeder Schalter ist in Fig. 7e durch einen Chip repräsentiert. Eine Parallelschaltung mehrerer Chips zur Erhöhung der Stromtragfähigkeit ist möglich.

Es werden für alle Beispiele also für die Netzfrequenz erste Schalter S1, S2 gleicher Temperaturbeständigkeit eingesetzt werden und für die höhere Taktfrequenz schnellere Schalter S3, S4 mit steileren Schaltflanken und höherer Temperaturbeständigkeit eingesetzt, wobei die ersten Schalter S1, S2, hier beispielhaft als obere Schalter bezeichnet, von den zweiten Schalter S3, S4, hier beispielhaft als obere Schalter bezeichnet, räumlich getrennt angeordnet sind.

Die Erfindung ist nicht auf diese Beispiele beschränkt. So können die Schaltungen nach Fig. 4 oder Fig. 6 auch dreiphasig sein. Auch andere Brückenschaltungen mit einer anderen Schalteranordnung und/oder einer anderen Schalteranzahl und/oder anderen Freilaufdioden können mit der Erfindung kombiniert werden. Die Schaltungen sind vorzugsweise transformatorlos. Lösungen mit einem Transformator sind aber auch möglich. Auch Hochsetz- und/oder Tiefsetzsteller, MPP-Steuerungen, Impulsweitensteuerungen und andere übliche Verfahren können genutzt werden.

### BEZUGSZEICHENLISTE

- PVG: PHOTOVOLTAIKGENERATOR
- N: Wechselspannungsnetz
- S1-S4: Schalter
- S5: Entkopplungsschalter
- Cz, Cz1, Cz2: Pufferkondensator
- LAC1, LAC2: Netzdrossel
- D1, D2: Freilaufdioden
- Cs1, Cs2: Stützkondensatoren
- Ls: parasitäre Induktivität
- Us: induzierte Spannung
- K1, K2: Kühlkörper
- H: Halbleitermodul
- P: Platine
- BP: Bodenplatte
- OE: Öffnung
- G: Kunsstoffgehäuse
- SU1, SU2: Substrate
- WA1, WA2: Wechselstromanschlüsse
- GS1-GS5: Steueranschlüsse
- PIN: Pins
- AP: Anschluss-PIN (Schalter)

## Patentansprüche

1. Wechselrichter zur Einspeisung einer Leistung einer Gleichspannungsquelle, insbesondere eines Photovoltaikgenerators (PVG) in ein Wechselspannungsnetz (N), mit einer asymmetrisch getakteten Brückenschaltung mit mindestens zwei mit Netzfrequenz getakteten ersten Schaltern (S1, S2) und mit mindestens zwei mit einer höheren Taktfrequenz getakteten zweiten Schaltern (S3, S4),
**dadurch gekennzeichnet,**
**dass** für die mit Netzfrequenz langsam schaltenden Schalter (S1, S2) solche gleicher Temperaturbeständigkeit eingesetzt werden, dass für die mit höherer Taktfrequenz schnell schaltenden Schalter (S3, S4) solche mit steileren Schaltflanken und höherer Temperaturbeständigkeit eingesetzt werden, wobei die schnell schaltenden Schalter (S3, S4) von den langsam schaltenden Schaltern (S1, S2) räumlich getrennt angeordnet sind, dass mindestens ein zusätzlicher Stützkondensator (Cs) nah an den schnell schaltenden Schaltern (S3, S4) angeschlossen ist, dass die langsam schaltenden Schalter (S1, S2) in einer ersten Bauteilgruppe angeordnet sind, während die schnell schaltenden Schalter (S3, S4) in einer zweiten Bauteilgruppe räumlich getrennt angeordnet sind und dass die erste Bauteilgruppe auf einem ersten Substrat und die zweite Bauteilgruppe auf einem zweiten Substrat angeordnet sind.

2. Wechselrichter nach Anspruch 1,
**dadurch gekennzeichnet,**
**dass** für die schnell schaltenden Schalter (S3, S4) und die langsam schaltenden Schalter (S1, S2) jeweils verschiedene Kühlkörper (K1, K2) vorhanden sind, auf denen die Schalter montiert sind.

3. Wechselrichter nach Anspruch 1 oder 2,
**dadurch gekennzeichnet,**
**dass** die Schalter in mindestens einem oder mehreren Halbleitermodulen (H) integriert sind.

4. Wechselrichter nach Anspruch 3,
**dadurch gekennzeichnet,**
**dass** die Schalter S1 bis S4 und Dioden D1 und D2 als Chips innerhalb eines Moduls (H) ausgeführt sind.

5. Wechselrichter nach einem der vorhergehenden Ansprüche,
**dadurch gekennzeichnet,**
**dass** die schnell schaltenden Schalter (S3, S4) als SiC-Bauelemente ausgeführt sind.

6. Wechselrichter nach Anspruch 5,
**dadurch gekennzeichnet,**
**dass** die schnell schaltenden Schalter (S3, S4) als SiC-FETs ausgeführt sind.

7. Wechselrichter nach einem der vorhergehenden Ansprüche,
**dadurch gekennzeichnet,**
**dass** die langsam schaltenden Schalter (S1, S2) als Si-Bauelemente ausgeführt sind.

8. Wechselrichter nach Anspruch 7,
**dadurch gekennzeichnet,**
**dass** die langsam schaltenden Schalter (S1, S2) als MOSFETs oder IGBTs ausgeführt sind.

9. Wechselrichter nach einem der vorhergehenden Ansprüche,
**dadurch gekennzeichnet,**
**dass** mindestens ein Entkopplungsschalter (S5) angeschlossen ist, der synchron mit den schnell schaltenden Schaltern (S3, S4) getaktet ist.

10. Wechselrichter nach Anspruch 9,
**dadurch gekennzeichnet,**
**dass** zwischen der Gleichspannungsquelle und der Brückenschaltung der Entkopplungsschalter (S5) angeschlossen ist.

11. Wechselrichter nach Anspruch 9 oder 10,
**dadurch gekennzeichnet,**
**dass** der bzw. die Entkopplungsschalter (S5) als SiC-Bauelemente, insbesondere als SiC-FETs ausgeführt sind.

12. Wechselrichter nach einem der vorhergehenden Ansprüche,
**dadurch gekennzeichnet,**
**dass** parallel an den langsamen Schaltern (S1, S2) Freilaufdioden (D1, D2) geschaltet sind, insbesondere dass die Freilaufdioden als Schottky-Dioden ausgeführt sind und/oder dass die Freilaufdioden räumlich den schnell schaltenden Schaltern (S3, S4) zugeordnet sind.

13. Wechselrichter nach einem der vorhergehenden Ansprüche, **gekennzeichnet durch**
eine Ausführung als Multi-Level-Wechselrichter, insbesondere als Drei-Level-Wechselrichter.

14. Wechselrichter nach einem der vorhergehenden Ansprüche, **gekennzeichnet durch**
eine Ausführung als Photovoltaikwechselrichter.

## Claims

1. An inverter for feeding power of a DC source, in particular a photovoltaic generator (PVG) into an AC grid (N), with an asynchronously clocked bridge circuit comprising at least two first switches (S1, S2) clocked at grid frequency and at least two second switches (S3, S4) clocked at a higher clocking frequency,
**characterized in that**
for the slow clocked switches (S1, S2) at grid frequency switches with same temperature persistence are used, that for the fast clocked switches (S3, S4) with higher frequency switches with steeper switching slope and higher temperature persistence are used, wherein the fast clocked switches (S3, S4) are arranged spaced apart from the slow clocked switches (S1, S2), that at least one additional support capacitor (Cs) is connected close to the fast clocked switches (S3, S4), that the slow clocked switches (S1, S2) are arranged in a first assembly, while the fast clocked switches (S3, S4) are arranged spaced apart in a second assembly, and that the first assembly is arranged on a first substrate, and the second assembly is arranged on a second substrate.

2. The inverter of claim 1,
**characterized in that**
for the fast clocked switches (S3, S4) and the slow clocked switches (S1, S2) different cooling bodies (K1, K2) are provided each, on which the switches are mounted.

3. The inverter of claim 1 or 2,
**characterized in that**
the switches are integrated into at least one or more semiconductor modules (H).

4. The inverter of claim 3,
**characterized in that**
the switches S1 to S4 and diodes D1 and D2 are provided as chips within a module (H).

5. The inverter of any of the preceding claims,
**characterized in that**
the fast clocked switches (S3, S4) are provided as SiC components.

6. The inverter of claim 5,
**characterized in that**
the fast clocked switches (S3, S4) are provided as SiC-FETs.

7. The inverter of any of the preceding claims,
**characterized in that**
the slow clocked switches (S1, S2) are provided as Si components.

8. The inverter of claim 7,
**characterized in that**
the slow clocked switches (S1, S2) are provided as MOSFETs or IGBTs.

9. The inverter of any of the preceding claims,
**characterized in that**
at least one decoupling switch (S5) being clocked synchronously to the fast clocked switches (S3, S4) is connected.

10. The inverter of claim 9,
**characterized in that**
the decoupling switch (S5) is connected between the DC source and the bridge circuit.

11. The inverter of claim 9 or 10,
**characterized in that**
the at least one or more decoupling switches (S5) are provided as SiC components, in particular as SiC-FETs.

12. The inverter of any of the preceding claims,
**characterized in that**
freewheeling diodes (D1, D2), in particular provided as Schottky-Diodes, are connected in parallel to the slow clocked switches (S1, S2) and/or the freewheeling diodes are spatially associated with the fast clocked switches (S3, S4).

13. The inverter of any of the preceding claims,
**characterized by**
an implementation as multi-level inverter, in particular as three-level inverter.

14. The inverter of any of the preceding claims,
**characterized by**
an implementation as photovoltaic inverter.

## Revendications

1. Onduleur destiné à injecter une puissance d'une source de tension continue, notamment d'un générateur photovoltaïque (PVG) dans un réseau de tension alternative (N), comprenant un circuit en pont à cadencement asymétrique pourvu d'au moins deux premiers commutateurs (S1, S2) cadencés à la fréquence du réseau et pourvu d'au moins deux deuxièmes commutateurs (S3, S4) cadencés à une fréquence d'horloge plus élevée, **caractérisé en ce que**
des commutateurs à commutation lente (S1, S2) ayant la même résistance à la température sont utilisés pour la fréquence du réseau, **en ce que** des commutateurs à commutation rapide (S3, S4) ayant des fronts de commutation plus raides et une résistance à la température supérieure sont utilisés pour la fréquence d'horloge plus élevée, les commutateurs à commutation rapide (S3, S4) étant disposés séparés dans l'espace des commutateurs à commutation lente (S1, S2), **en ce qu'**au moins un condensateur de maintien (Cs) supplémentaire est raccordé à proximité des commutateurs à commutation rapide (S3, S4), **en ce que** les commutateurs à commutation lente (S1, S2) sont disposés dans un premier groupe de composants, alors que les commutateurs à commutation rapide (S3, S4) sont disposés dans un deuxième groupe de composants séparé dans l'espace, et **en ce que** le premier groupe de composants est disposé sur un premier substrat et le deuxième groupe de composants sur un deuxième substrat.

2. Onduleur selon la revendication 1, **caractérisé en ce qu'**il existe respectivement des radiateurs (K1, K2) différents pour les commutateurs à commutation rapide (S3, S4) et les commutateurs à commutation lente (S1, S2), sur lesquels sont montés les commutateurs.

3. Onduleur selon la revendication 1 ou 2, **caractérisé en ce que** les commutateurs sont intégrés dans au moins un ou plusieurs modules à semiconducteur (H).

4. Onduleur selon la revendication 3, **caractérisé en ce que** les commutateurs S1 à S4 et des diodes D1 à D2 sont réalisés sous la forme de puces à l'intérieur d'un module (H).

5. Onduleur selon l'une des revendications précédentes, **caractérisé en ce que** les commutateurs à commutation rapide (S3, S4) sont réalisés sous la forme de composants en SiC.

6. Onduleur selon la revendication 5, **caractérisé en ce que** les commutateurs à commutation rapide (S3, S4) sont réalisés sous la forme de SiC-FET.

7. Onduleur selon l'une des revendications précédentes, **caractérisé en ce que** les commutateurs à commutation lente (S1, S2) sont réalisés sous la forme de composants en Si.

8. Onduleur selon la revendication 7, **caractérisé en ce que** les commutateurs à commutation lente (S1, S2) sont réalisés sous la forme de MOSFET ou d'IGBT.

9. Onduleur selon l'une des revendications précédentes, **caractérisé en ce qu'**au moins un commutateur de découplage (S5) est raccordé, lequel est cadencé de manière synchrone avec les commutateurs à commutation rapide (S3, S4).

10. Onduleur selon la revendication 9, **caractérisé en ce que** le commutateur de découplage (S5) est raccordé entre la source de tension continue et le circuit en pont.

11. Onduleur selon la revendication 9 ou 10, **caractérisé en ce que** le ou les commutateurs de découplage (S5) sont réalisés sous la forme de composants en SiC, notamment de SiC-FET.

12. Onduleur selon l'une des revendications précédentes, **caractérisé en ce que** des diodes de roue libre (D1, D2) sont branchées en parallèle avec les commutateurs à commutation lente (S1, S2), notamment **en ce que** les diodes de roue libre sont réalisées sous la forme de diodes Schottky et/ou **en ce que** les diodes de roue libre sont associées dans l'espace aux commutateurs à commutation rapide (S3, S4).

13. Onduleur selon l'une des revendications précédentes, **caractérisé par** une exécution sous la forme d'un onduleur multiniveaux, notamment d'un onduleur à trois niveaux.

14. Onduleur selon l'une des revendications précédentes, **caractérisé par** une exécution sous la forme d'un onduleur photovoltaïque.
